# EUROPEAN PATENT APPLICATION

(11) **EP 4 632 801 A1**
(43) Date of publication of application: **15.10.2025**
(21) Application number: 25167632.6
(22) Date of filing: 01.04.2025
(51) Int. Cl.: H01L 21/67

(54) **GAS MANAGEMENT ASSEMBLY FOR SUBSTRATE PROCESSING APPARATUS**

(30) Priority: 10.04.2024 US 202418631606
(71) Applicant: HPSP Co., Ltd., Hwaseong-si, Gyeonggi-do 18449 (KR)
(72) Inventor: Coto, Jose Salvador, Sunnyvale, CA 94085 (US); Rivera, Manuel Scott, Sunnyvale, CA 94085 (US); Zhang, Xiaoping, Sunnyvale, CA 94085 (US)
(74) Representative: von Bülow & Tamada

(57) **Abstract**

A gas management assembly for a substrate processing apparatus includes: an exhaust module including a basic exhaust line that is formed to exhaust a chamber gas containing a process gas supplied to a chamber of the substrate processing apparatus to a discharge system; a recovery connection module including a recovery exhaust line that is branched from the basic exhaust line and formed to exhaust the chamber gas to a recovery system; and a control module configured to perform automatic switching of an exhaust path of the chamber gas from one of the basic exhaust line and the recovery exhaust line to the other based on at least one of an operation mode of the substrate processing apparatus, a pressure of the chamber, or a pressure of the recovery exhaust line.

## Description

### BACKGROUND

### Field

The present invention relates to a gas management assembly that supplies a gas to and exhausts a gas from a chamber of a substrate processing apparatus.

### Description of the Related Art

Generally, during a semiconductor device manufacturing process, various types of processing are performed on a semiconductor substrate. Examples of such processing include oxidation, nitriding, silicide, ion implantation, and deposition processes. There is also a hydrogen or deuterium heat treatment process to improve interfacial properties of the semiconductor device.

A gas for the processing is supplied into a chamber and acts on the semiconductor substrate. The supplied gas also needs to be exhausted from the chamber after the processing.

The gas exhausted from the chamber may be released with process by-products and other hazardous components filtered out. The exhaust gases also contain expensive gases. It is a huge economic waste for such expensive gases to be used only once and then discarded.

The related art described above is technical information that the present inventors have possessed in order to derive exemplary embodiments of the present invention or have acquired in a process of deriving the exemplary embodiments of the present invention, and is not necessarily a known technology disclosed to the general public before the present application.

### SUMMARY

An object of the present invention is to provide a gas management assembly for a substrate processing apparatus that enhances economic efficiency of substrate processing by recovering and reusing an exhaust gas.

Another object of the present invention is to provide a gas management assembly for a substrate processing apparatus that may selectively operate a recovery system to enhance recovery efficiency for an exhaust gas.

Another object of the present invention is to provide a gas management assembly for a substrate processing apparatus that enables easy additional installation of a recovery system in a case where the recovery system is not applied in initial manufacturing.

According to an exemplary embodiment of the present invention, a gas management assembly for a substrate processing apparatus includes: an exhaust module including a basic exhaust line that is formed to exhaust a chamber gas containing a process gas supplied to a chamber of the substrate processing apparatus to a discharge system; a recovery connection module including a recovery exhaust line that is branched from the basic exhaust line and formed to exhaust the chamber gas to a recovery system; and a control module configured to perform automatic switching of an exhaust path of the chamber gas from one of the basic exhaust line and the recovery exhaust line to the other based on at least one of an operation mode of the substrate processing apparatus, a pressure of the chamber, or a pressure of the recovery exhaust line.

The exhaust module may include a gas exhauster installed in the basic exhaust line and formed to adjust an exhaust amount of the chamber gas, and a basic line valve installed downstream of the gas exhauster in the basic exhaust line and formed to control a flow of the chamber gas to the discharge system, the recovery connection module may include a recovery line valve installed in the recovery exhaust line in such a way as to be positioned downstream of the gas exhauster and formed to control a flow of the chamber gas to the recovery exhaust line, and the control module may control opening and closing of the basic line valve and the recovery line valve for the automatic switching.

The control module may switch the exhaust path to the basic exhaust line in a case where the operation mode is at least one of a process start mode, a process end mode, or a process abort mode.

The control module may switch the exhaust path to the recovery exhaust line in a case where the operation mode is a processing mode and the pressure of the chamber is equal to or higher than a minimum switching pressure.

The minimum switching pressure may be higher than atmospheric pressure.

The control module may switch the exhaust path to the basic exhaust line in a case where the operation mode is the processing mode and the pressure of the chamber exceeds a maximum switching pressure, and the maximum switching pressure may be higher than the minimum switching pressure.

The control module may perform the automatic switching to the recovery exhaust line only when the recovery system is ready for operation.

The chamber gas may contain deuterium.

The control module may open both of the basic exhaust line and the recovery exhaust line during a delay time in a case where the automatic switching is performed.

The delay time may be within a few seconds.

The gas management assembly may further include: a housing having an internal space that accommodates the exhaust module and the recovery connection module; and a charging module configured to charge the internal space with a protective gas at a pressure higher than an external pressure of the housing.

The housing may include a main housing accommodating at least a part of the exhaust module, and an auxiliary housing accommodating the recovery connection module.

The main housing and the auxiliary housing may communicate with each other, and the charging module may communicate with only one of the main housing and the auxiliary housing.

The gas management assembly may further include a gas supply module formed to supply the process gas to the chamber at a pressure higher than atmospheric pressure, in which the substrate processing apparatus may process a substrate at a pressure higher than the atmospheric pressure.

### BRIEF DESCRIPTION OF THE DRAWINGS

FIG. 1 is a conceptual diagram of a gas management assembly for a substrate processing apparatus according to an exemplary embodiment of the present invention;
FIG. 2 is a block diagram for describing a control configuration of the gas management assembly for a substrate processing apparatus of FIG. 1;
FIG. 3 is a conceptual diagram of a gas management assembly for a substrate processing apparatus according to another exemplary embodiment of the present invention;
FIG. 4 is a flowchart illustrating a manner in which a control module controls exhaustion of a chamber gas;
FIG. 5 is a flowchart illustrating a specific example of steps (S3 and S5) of FIG. 4; and
FIGS. 6A and 6B are conceptual diagrams for describing an automatic switching timing of the control module.

### DETAILED DESCRIPTION

Hereinafter, preferred exemplary embodiments of the present invention will be described in detail with reference to the accompanying drawings.

The present invention is not limited to exemplary embodiments disclosed below, but may be subject to various changes and may be implemented in various different forms. A description for the exemplary embodiments will be provided only to make the present disclosure complete and allow those skilled in the art to completely recognize the scope of the present invention. Therefore, it is to be understood that the present invention is not limited to the exemplary embodiments disclosed below, but include substitution between or addition of the configuration of one exemplary embodiment and the configuration of another exemplary embodiment, and all modifications, equivalents, and substitutions included in the spirit and the scope of the present invention.

It is to be understood that the accompanying drawings are provided only in order to allow the exemplary embodiments disclosed in the present specification to be easily understood, and the spirit of the present invention is not limited by the accompanying drawings, but includes all the modifications, equivalents, and substitutions included in the spirit and the scope of the present invention. In the drawings, components may be expressed exaggeratedly large or small in size or thickness for convenience of understanding, but the scope of protection of the present invention should not be construed as being limited thereto.

Terms used in the present specification are used only in order to describe specific exemplary embodiments rather than limit the present invention. Singular forms are intended to include plural forms unless the context clearly indicates otherwise. In the specification, terms such as "include", and "have" are intended to designate the presence of features, numerals, steps, operations, components, parts, or a combination thereof described in the specification. It is to be understood that the terms such as "include" and "have" used in the present specification do not preclude the presence or addition of one or more other features, numerals, steps, operations, components, parts, or a combination thereof.

Terms including ordinal numbers such as "first" and "second" may be used to describe various components. However, these components are not limited by these terms. The terms are used only to distinguish one component from another component.

It is to be understood that in a case where one component is referred to as being "connected to" or "coupled to" another component, one component may be connected directly to or coupled directly to another component or be connected to or coupled to another component with the other component interposed therebetween. On the other hand, it is to be understood that in a case where one component is referred to as being "connected directly to" or "coupled directly to" another component, it may be connected to or coupled to another component without the other component interposed therebetween.

When one component is referred to as being "above" or "below" another component, it is to be understood that the one component may be directly on the another component or may be on the another component while having the other component intervening therebetween.

Unless defined otherwise, it is to be understood that all the terms used in the present specification including technical and scientific terms have the same meanings as those generally understood by those skilled in the art to which the present invention pertains. It should be interpreted that terms defined by a generally used dictionary are identical with the meanings within the context of the related art, and they should not be ideally or excessively formally interpreted unless the context clearly dictates otherwise.

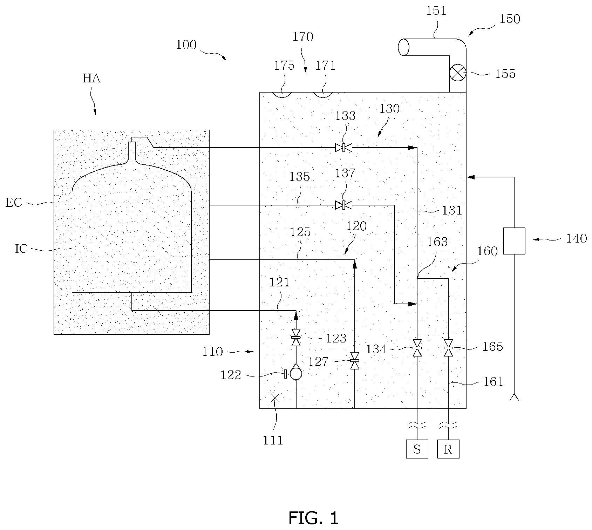

FIG. 1 is a conceptual diagram of a gas management assembly for a substrate processing apparatus according to an exemplary embodiment of the present invention.

Referring to FIG. 1, a gas management assembly 100 is configured to supply gases to chambers IC and EC of a high-pressure substrate processing apparatus HA and exhaust gases from the chambers IC and EC. The gas management assembly 100 may be understood as a part of the high-pressure substrate processing apparatus HA.

The high-pressure substrate processing apparatus HA will be described focusing on the chambers IC and EC as follows. The chambers may include an inner chamber IC and an outer chamber EC.

The inner chamber IC may form a processing space that accommodates a substrate to be processed. The inner chamber IC may be formed of a non-metallic material, such as quartz, to reduce contamination in high-pressure and high-temperature working environments. Although simplified in the drawing, a door (not illustrated) that opens and closes the processing space may be provided at a lower end of the inner chamber IC. As the door descends, the processing space is opened, and the substrate may be put into the inner chamber IC while being mounted on a holder (not illustrated). The inner chamber IC may be heated to hundreds to thousands °C by an operation of a heater (not illustrated) disposed outside the inner chamber IC. The substrate may be, for example, a semiconductor wafer. In this case, the holder may be a wafer boat in which the semiconductor wafers may be stacked in multiple layers.

The outer chamber EC is formed to accommodate the inner chamber IC. Unlike the inner chamber IC, the outer chamber EC is free from contamination problems. Therefore, the outer chamber EC may be formed of a metal material. The outer chamber EC may also include a door (not illustrated). The door of the outer chamber EC may be opened in conjunction with the door of the inner chamber IC. The inner chamber IC may be mounted in the outer chamber EC.

Hereinafter, the gas management assembly 100 will be described. The gas management assembly 100 may include a housing 110, a gas supply module 120, an exhaust module 130, a charging module 140, a discharge module 150, a recovery connection module 160, and a detection module 170.

The housing 110 may have an internal space 111. The housing 110 may have a body having a substantially rectangular parallelepiped shape. The gas supply module 120 and the exhaust module 130 may be installed in the internal space 111.

The gas supply module 120 is configured to supply gases to the chambers IC and EC. The gas supply module 120 may communicate with a utility line (gas supply line) of a semiconductor factory. The gas supply module 120 may include a first supply line 121 communicating with the inner chamber IC and a second supply line 125 communicating with the outer chamber EC.

Gases for processing the substrate such as hydrogen gas (H₂), deuterium gas (D₂), fluorine gas (F₂), ammonia gas (NH₃), chlorine gas (Cl₂), and nitrogen gas (N₂) may be selectively supplied to the inner chamber IC through the first supply line 121. An inert gas such as nitrogen gas or argon gas (Ar) may be supplied to the outer chamber EC through the second supply line 125. Specifically, the gas introduced into the outer chamber EC is supplied to a space between the outer chamber EC and the inner chamber IC. The hydrogen gas introduced into the inner chamber IC, the nitrogen gas introduced into the outer chamber EC, and the like may all be collectively referred to as process gases.

The process gas may be supplied to form a high pressure higher than atmospheric pressure, for example, from several to tens of atmospheres. When a pressure of the gas supplied to the inner chamber IC is a first pressure and a pressure of the gas supplied to the outer chamber EC is a second pressure, the second pressure may be set in relation to the first pressure. For example, the second pressure may be set to be somewhat higher than the first pressure. Such a pressure difference provides an advantage that a gas within the inner chamber IC does not leak and the inner chamber IC is not damaged.

A control supplier 122 may be installed in the first supply line 121 to establish and maintain a relationship between the first pressure and the second pressure. The control supplier 122 may supply a gas while measuring the amount of gas introduced into the inner chamber IC. For example, the control supplier 122 may be a mass flow controller (MFC). An opening and closing supplier 123 may be installed downstream of the control supplier 122 to open and close the first supply line 121. An opening and closing supplier 127 may be installed in the second supply line 125. Unlike the control supplier 122, the opening and closing supplier 127 does not measure a flow rate. Opening and closing of the opening and closing supplier 127 may be controlled based on a pressure of the outer chamber EC.

The exhaust module 130 is configured to exhaust gases (chamber gases) from the chambers IC and EC. The chamber gas may be a mixture of the process gas and process by-products such as particles derived from the substrate. The chamber gas may be a gas having a high temperature due to a high temperature process, for example, a temperature higher than an ignition point of the process gas. The exhaust module 130 may communicate with a utility line (gas exhaust line) of the semiconductor factory.

The exhaust module 130 may include a first exhaust line 131 for exhausting the gas from the inner chamber IC and a second exhaust line 135 for exhausting the gas from the outer chamber EC. The first exhaust line 131 may communicate with an upper portion of the inner chamber IC and may extend outside the outer chamber EC. A gas exhauster 133 may be installed in the first exhaust line 131. The second exhaust line 135 may communicate with the outer chamber EC and include a gas exhauster 137. The gas exhausters 133 and 137 may adjust the pressures of the chambers IC and EC by adjusting exhaust amounts of the process gas and the chamber gas. The gas exhausters 133 and 137 may be, for example, flow control valves. In a case where the first exhaust line 131 and the second exhaust line 135 converge, an active gas such as the hydrogen gas or the deuterium gas in the chamber gas is diluted with the inert gas, and a concentration of the active gas is thus lowered.

The charging module 140 is configured to charge the internal space 111 with a protective gas. The protective gas may be, for example, an inert gas. Examples of the inert gas may include nitrogen gas and argon gas.

As the internal space 111 is charged with the protective gas, a pressure (a third pressure) of the internal space 111 has a characteristic different from the first pressure and the second pressure. The third pressure is higher than an external pressure of the housing 110 (usually, atmospheric pressure), but lower than the first pressure and the second pressure. Specifically, the third pressure has a value biased toward the external pressure rather than the first pressure and the second pressure, and may be slightly higher than the atmospheric pressure. For example, the third pressure may be tens to hundreds of Pa higher than the atmospheric pressure. It is sufficient if the third pressure is set to a level that may block external air (oxygen) from flowing into the internal space 111.

The discharge module 150 is configured to discharge a gas in the internal space 111 to the outside. The gas in the internal space 111 is mainly the protective gas, but may also be a mixed gas in which the chamber gas is contained. The mixed gas may be generated in a case where leakage of the process gas or the chamber gas occurs in the gas supply module 120 or the exhaust module 130.

The discharge module 150 may include a discharge duct 151 communicating with the internal space 111. The discharge duct 151 may communicate with the utility line (gas exhaust line) of the semiconductor factory. A gate valve 155 may be installed in the discharge duct 151. The gate valve 155 may be opened in a case where the gas in the internal space 111 needs to be discharged.

The recovery connection module 160 is configured to guide the chamber gas (specifically, the gas discharged from the inner chamber IC) to a recovery system. The recovery connection module 160 may include a recovery exhaust line 161 branched from the first exhaust line (basic exhaust line) 131 and connected to the recovery system. A branch point 163 where the recovery exhaust line 161 is branched may be positioned in the internal space 111. The recovery system may enable recovery and reuse of a major gas in the chamber gas, such as expensive deuterium gas. The recovery system may include a reclaimer R. A recovery line valve 165 may be installed in the recovery exhaust line 161. The recovery line valve 165 may be an opening and closing valve that controls the recovery exhaust line 161. In an alternative exemplary embodiment, the major gas may include hazardous gases as well as expensive gases. Although the hazardous gases are recovered in the recovery system, the hazardous gases may not be reused. Specifically, the hazardous gas may be processed independently from other gases in a dedicated scrubber.

A basic line valve 134 may be installed in the basic exhaust line 131 at a position corresponding to the recovery line valve 165. The basic line valve 134 is a valve that controls the basic exhaust line 131. The basic line valve 134 and the recovery line valve 165 may be installed downstream of a gas discharger 133 along an exhaust path of the chamber gas. When the basic line valve 134 is opened and the recovery line valve 165 is closed, the chamber gas flows through the basic exhaust line 131 to a discharge system. The discharge system may filter and discharge the process by-products from the chamber gas. The discharge system may include a scrubber S for collecting the process by-products. Unlike the above, when the basic line valve 134 is closed and the recovery line valve 165 is opened, the chamber gas may flow to the reclaimer R through the recovery exhaust line 161. In a case where the second exhaust line 135 and the first exhaust line 131 converge at a portion of the first exhaust line 131 positioned downstream of the branch point 163, the inert gas from the outer chamber EC may only be introduced into the scrubber S. Since the inert gas has a low need for recovery, the inert gas does not need to be sent to the reclaimer R.

The detection module 170 may include a pressure gauge 171 and a gas detector 175 to detect an environment of the internal space 111. The pressure gauge 171 may be used to detect a gas pressure in the internal space 111. Although not illustrated in FIG. 1, the pressure gauge 171 may additionally include a gauge that detects pressures of the chambers IC and EC and the recovery exhaust line 161. The gas detector 175 may be used to detect the process gas (specifically, an active gas such as hydrogen) leaking into the internal space 111 and a gas such as oxygen introduced from the outside.

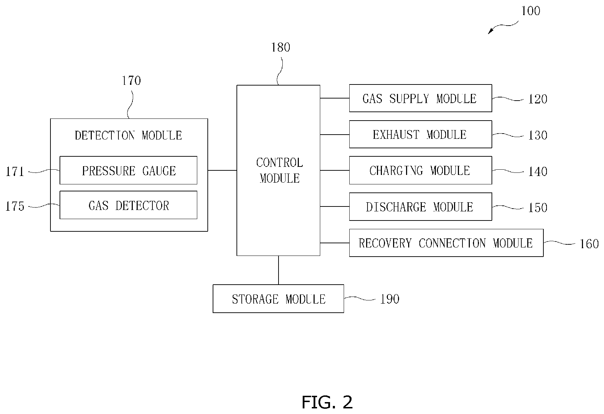

A control configuration of the gas management assembly 100 will be described with reference to FIG. 2. FIG. 2 is a block diagram for describing the control configuration of the gas management assembly for a substrate processing apparatus of FIG. 1.

Referring to FIG. 2 (and FIG. 1), the gas management assembly 100 may further include a control module 180 and a storage module 190, in addition to the gas supply module 120, the exhaust module 130, the charging module 140, and the like described above.

The control module 180 is configured to control the gas supply module 120, the exhaust module 130, and the like. The control module 180 may control the charging module 140, the discharge module 150, and the like based on a detection result of the detection module 170.

The storage module 190 is configured to store data that the control module 180 may refer to for control, programs, and the like.

With such a configuration, the control module 180 may perform control to charge the internal space 111 with the protective gas or to discharge the gas in the internal space 111 with the leakage of the process gas based on the detection result of the detection module 170. For the former, the control module 180 may control the charging module 140, and for the latter, the control module 180 may control the discharge module 150.

The control module 180 may control the charging module 140 along with the discharge module 150 to allow the protective gas to be introduced into the internal space 111 when the gas in the internal space 111 is discharged. Therefore, a concentration of the chamber gas may be lowered when the chamber gas leaks into the internal space 111. The introduction of the protective gas also promotes the discharge of the chamber gas.

The control module 180 may exhaust the gas in the internal space 111 and also exhaust the gases in the chambers IC and EC. This is because the processing in the chambers IC and EC may not proceed any further when a problem occurs due to leakage in the gas supply assembly 100. The control module 180 may control the exhaust module 130 to exhaust the gases in the chambers IC and EC.

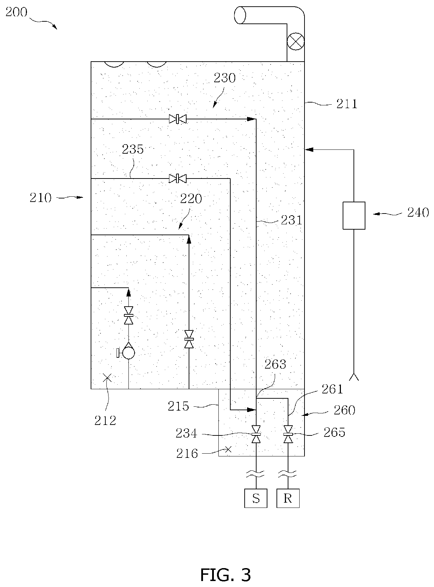

Another form of the gas management assembly 100 will be described with reference to FIG. 3. FIG. 3 is a conceptual diagram of a gas management assembly for a substrate processing apparatus according to another exemplary embodiment of the present invention.

Referring to FIG. 3, a gas management assembly 200 is substantially the same as the gas management assembly 100 according to the exemplary embodiment described above, but differs in configurations of a housing 210 and a recovery connection module 260. A configuration of a high-pressure heat treatment device HA (see FIG. 1) is omitted in FIG. 3. Further, the same components of the gas management assembly 200 as those of the exemplary embodiment described above may not be further described even when the components are illustrated in FIG. 3.

The housing 210 may be divided into a main housing 211 and an auxiliary housing 215. A gas supply module 220, an exhaust module 230, and the like are disposed in an internal space 212 of the main housing 211. A charging module 240 and the like may communicate with the internal space 212. The auxiliary housing 215 is mounted on the main housing 211 and may have an internal space 216. The internal space 216 may have a smaller volume than the internal space 212.

A portion of a basic exhaust line 231 and a branch point 263 where a recovery exhaust line 261 is branched from the basic exhaust line 231 may be positioned in the internal space 216. A basic line valve 234 and a recovery line valve 265 may also be positioned in the internal space 216.

The internal space 216 may communicate with the internal space 212. In this case, the internal space 212 may also be charged with the protective gas by the charging module 240. In an alternative exemplary embodiment, the internal space 216 may be configured independently from the internal space 212, and a separate protective gas charging line may be connected to the internal space 216. Alternatively, the charging module 240 may charge the internal space 216 with the protective gas in a state in which the internal space 216 communicates with the internal space 212.

With such a configuration, the recovery connection module 260 may be installed through the auxiliary housing 215 mounted on the main housing 211. Therefore, additional installation of the recovery connection module 260 may be easily performed even in a case where the recovery connection module 260 is not applied at the time of initial manufacturing of the gas management assembly 200. In other words, as the auxiliary housing 215 and the recovery connection module 260 are additionally installed on the outside of the main housing 211, no structural change of the main housing 211 (and components disposed inside the main housing 211) is required.

As the internal space 216 communicates with the internal space 212, the recovery connection module 260 may also be protected by the protective gas. Even in a case where gas leakage occurs at the branch point 263, the basic line valve 234, the recovery line valve 265, and the like, the leaked gas may not meet outside air due to the protective gas.

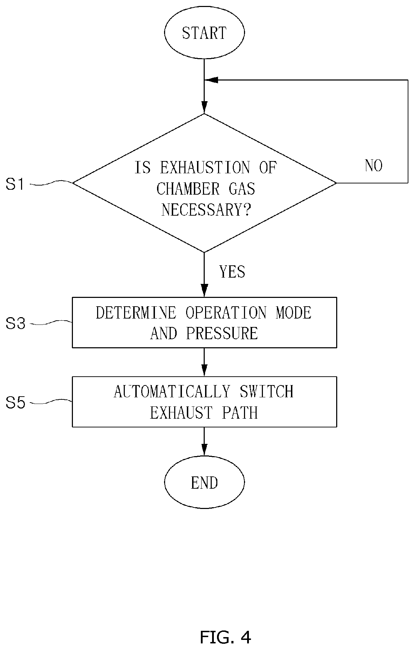

In a process of exhausting the chamber gas, the control module 180 of the gas management assembly 100 may comprehensively control the exhaust module 130 and the recovery connection module 160. A detailed description thereof will be provided with reference to FIGS. 4 to 6. A control-related content for the gas management assembly 100 may also be applied to the gas management assembly 200.

FIG. 4 is a flowchart illustrating a manner in which the control module controls exhaustion of the chamber gas.

Referring further to FIG. 4, the control module 180 determines whether or not exhaustion of the chamber gas is necessary (S1). The chamber gas may need to be exhausted in at least one of various operation modes of the chambers IC and EC, such as an idle mode, a standby mode, and a process mode.

In a case where exhaustion of the chamber gas is necessary, the control module 180 determines the operation mode of the chambers IC and EC and relevant pressures (S3). The relevant pressures may include the pressure of the inner chamber IC and the pressure of the recovery exhaust line 161. The pressure of the recovery exhaust line 161 may be a pressure of a gas measured in the reclaimer R (see FIG. 1).

The control module 180 may automatically switch the exhaust path of the chamber gas based on information such as the operation mode (S5). Specifically, the control module 180 may perform control to switch the exhaust path from one of the basic exhaust line 131 of the exhaust module 130 and the recovery exhaust line 161 of the recovery connection module 160 to the other. The control module 180 may switch the exhaust path to the recovery exhaust line 161 only when the recovery system is ready for operation. The control module 180 may control opening and closing of the basic line valve 134 and the recovery line valve 165 to switch the exhaust path.

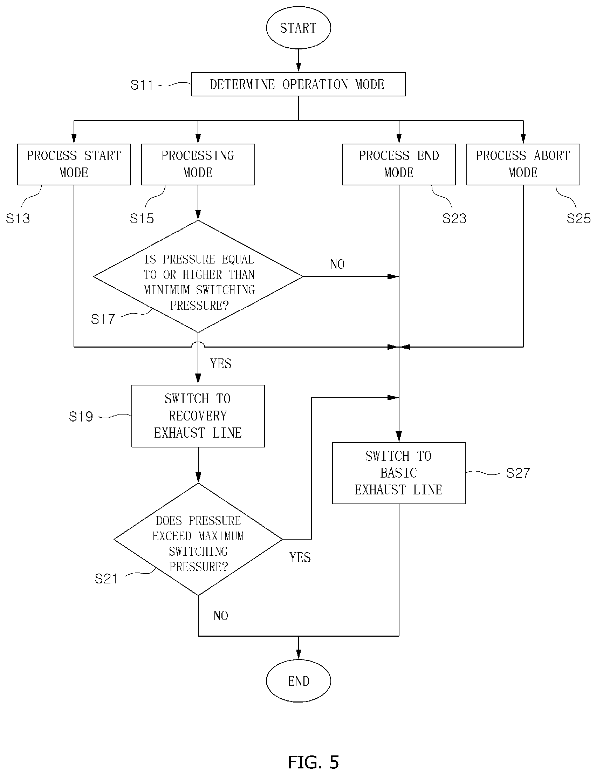

FIG. 5 is a flowchart illustrating a specific example of steps (S3 and S5) of FIG. 4.

Referring further to FIG. 5, the control module 180 determines the operation mode (S11). The operation mode may include a process start mode, a processing mode, a process end mode, and a process abort mode.

When the operation mode is the process start mode (S13), the process end mode (S23), and the process abort mode (S25), the control module 180 may switch the exhaust path to the basic exhaust line 131. To this end, the control module 180 may open the basic line valve 134 and close the recovery line valve 165. As a result, the chamber gas may flow to the scrubber S.

When the operation mode is the processing mode (S15), the control module 180 may determine whether or not the pressure of the inner chamber IC is equal to or higher than a minimum switching pressure (S17). In a case where the pressure of the inner chamber IC is equal to or higher than the minimum switching pressure, the control module 180 may switch the exhaust path to the recovery exhaust line 161 (S19). The control module 180 may close the basic line valve 134 and open the recovery line valve 165. Accordingly, the chamber gas may flow to the reclaimer R. The minimum switching pressure may be a pressure higher than the atmospheric pressure, but may be at a level that does not reach several atmospheres, for example.

In a case where the pressure of the inner chamber IC is lower than the minimum switching pressure (S17), the control module 180 may switch the exhaust path to the basic exhaust line 131 (S27). In a case where the pressure of the inner chamber IC is lower than the minimum switching pressure, it is difficult for the chamber gas to naturally flow to the recovery system. In addition, as natural exhaustion of the chamber gas is not smooth, the chamber gas in the inner chamber IC may be purged with a purge gas, for example, nitrogen gas. Even in a case where the chamber gas is purged and sent to the reclaimer R, recovery efficiency for the chamber gas is low because the chamber gas is diluted with the purge gas. In such a case, it may be better for the chamber gas to flow to the discharge system rather than to the recovery system.

The control module 180 may additionally determine whether or not the pressure of the recovery exhaust line 161 exceeds a maximum switching pressure (S21). In a case where the pressure of the recovery exhaust line 161 is equal to or lower than the maximum switching pressure, the control module 180 may maintain the recovery exhaust line 161 as the exhaust path. In a case where the pressure of the recovery exhaust line 161 exceeds the maximum switching pressure, the control module 180 may switch the exhaust path to the basic exhaust line 131 (S27). The maximum switching pressure may be at a level of several to tens of atmospheres, which is a level of pressure that ensures safe operation of the reclaimer R. The maximum switching pressure may have a value several times or tens of times higher than the minimum switching pressure.

Even in an operation mode other than the above-described operation modes, the control module 180 may perform switching of the exhaust path or maintain a state in which the switching is possible. For example, in the standby mode, the control module 180 may switch the exhaust path to the basic exhaust line 131. In the idle mode, in a case where the pressure of the inner chamber IC is lower than the minimum switching pressure or the pressure of the recovery exhaust line 161 is equal to or lower than the maximum switching pressure, the control module 180 may allow switching of the exhaust path to the recovery exhaust line 161 according to a manual operation by an operator.

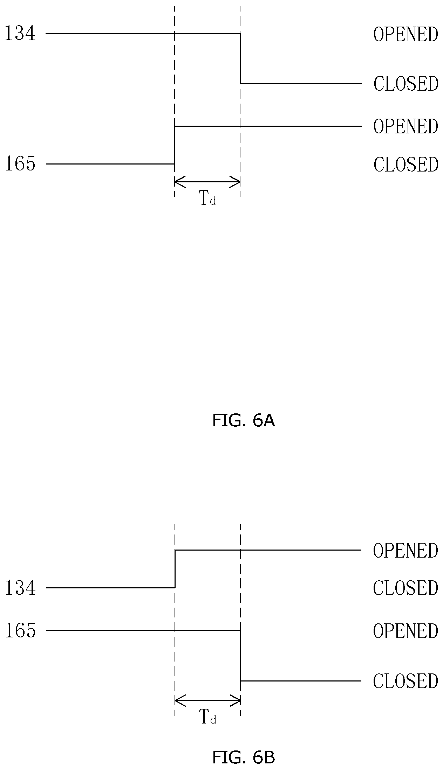

FIGS. 6A and 6B are conceptual diagrams for describing an automatic switching timing of the control module.

Referring further to FIGS. 6A and 6B, in a process of opening one of the basic exhaust line 131 and the recovery exhaust line 161 and closing the other, the control module 180 may open both of the basic exhaust line 131 and the recovery exhaust line 161 for a certain time. The time may be referred to as a delay time Td. The delay time may be within a few seconds.

Specifically, referring to FIG. 6A, in a state in which the basic line valve 134 is opened and the recovery line valve 165 is closed, switching to the opposite state may be made. To this end, the control module 180 needs to close the basic line valve 134 and open the recovery line valve 165. Closing the basic line valve 134 and opening the recovery line valve 165 may not be performed simultaneously, but may be performed with the delay time Td. Accordingly, the basic line valve 134 may be closed after the delay time Td elapses from the opening of the recovery line valve 165. The delay time Td may alleviate a pressure shock that may be applied to the chamber IC due to the switching of the exhaust path.

Referring to FIG. 6B, the delay time Td is secured even in the opposite case. Specifically, the recovery line valve 165 may be closed after the delay time Td elapses from the opening of the basic line valve 134.

In the present specification, the gas management assemblies 100 and 200 are described as being used in the high-pressure substrate processing apparatus (HA) by way of example, but the present invention is not limited thereto. The gas management assemblies 100 and 200 may also be applied to a substrate processing apparatus that processes a substrate at a pressure below the atmospheric pressure, rather than a high pressure. Furthermore, the present invention may also be applied to a substrate processing apparatus including a single chamber rather than a dual chamber (IC and EC). The present invention may also be applied to a single wafer type substrate processing apparatus as well as a batch type substrate processing apparatus.

In the gas management assembly for a substrate processing apparatus according to the present invention configured as described above, the control module performs automatic switching of the exhaust path between the basic exhaust line that exhausts the chamber gas to the discharge system and the recovery exhaust line that is branched from the basic exhaust line and exhausts the chamber gas to the recovery system based on the operation module of the high-pressure substrate processing apparatus, the pressure of the chamber, or the pressure of the recovery exhaust line. Therefore, it is possible to recover and reuse the chamber gas through the recovery system. In addition, when the recovery efficiency is high, the chamber gas may flow to the recovery system, thereby improving the recovery efficiency.

As the recovery connection module is installed in the auxiliary housing connected to the main housing, the recovery connection module may be applied later even in a case where the recovery connection module is not applied at the time of initial manufacturing. As a result, a function of recovering exhaust gases may be easily added to existing gas management assemblies.

## Claims

1. A gas management assembly for a substrate processing apparatus, the gas management assembly comprising:
an exhaust module including a basic exhaust line that is formed to exhaust a chamber gas containing a process gas supplied to a chamber of the substrate processing apparatus to a discharge system;
a recovery connection module including a recovery exhaust line that is branched from the basic exhaust line and formed to exhaust the chamber gas to a recovery system; and
a control module configured to perform automatic switching of an exhaust path of the chamber gas from one of the basic exhaust line and the recovery exhaust line to the other based on at least one of an operation mode of the substrate processing apparatus, a pressure of the chamber, or a pressure of the recovery exhaust line.

2. The gas management assembly of claim 1, wherein the exhaust module includes a gas exhauster installed in the basic exhaust line and formed to adjust an exhaust amount of the chamber gas, and a basic line valve installed downstream of the gas exhauster in the basic exhaust line and formed to control a flow of the chamber gas to the discharge system,
the recovery connection module includes a recovery line valve installed in the recovery exhaust line in such a way as to be positioned downstream of the gas exhauster and formed to control a flow of the chamber gas to the recovery exhaust line, and
the control module controls opening and closing of the basic line valve and the recovery line valve for the automatic switching.

3. The gas management assembly of claim 1, wherein the control module switches the exhaust path to the basic exhaust line in a case where the operation mode is at least one of a process start mode, a process end mode, or a process abort mode.

4. The gas management assembly of claim 1, wherein the control module switches the exhaust path to the recovery exhaust line in a case where the operation mode is a processing mode and the pressure of the chamber is equal to or higher than a minimum switching pressure.

5. The gas management assembly of claim 4, wherein the minimum switching pressure is higher than atmospheric pressure.

6. The gas management assembly of claim 4, wherein the control module switches the exhaust path to the basic exhaust line in a case where the operation mode is the processing mode and the pressure of the chamber exceeds a maximum switching pressure, and
the maximum switching pressure is higher than the minimum switching pressure.

7. The gas management assembly of claim 1, wherein the control module performs the automatic switching to the recovery exhaust line only when the recovery system is ready for operation.

8. The gas management assembly of claim 1, wherein the chamber gas contains deuterium.

9. The gas management assembly of claim 1, wherein the control module opens both of the basic exhaust line and the recovery exhaust line during a delay time in a case where the automatic switching is performed.

10. The gas management assembly of claim 9, wherein the delay time is within a few seconds.

11. The gas management assembly of claim 1, further comprising:
a housing having an internal space that accommodates the exhaust module and the recovery connection module; and
a charging module configured to charge the internal space with a protective gas at a pressure higher than an external pressure of the housing.

12. The gas management assembly of claim 11, wherein the housing includes a main housing accommodating at least a part of the exhaust module, and an auxiliary housing accommodating the recovery connection module.

13. The gas management assembly of claim 12, wherein the main housing and the auxiliary housing communicate with each other, and
the charging module communicates with only one of the main housing and the auxiliary housing.

14. The gas management assembly of claim 1, further comprising a gas supply module formed to supply the process gas to the chamber at a pressure higher than atmospheric pressure,
wherein the substrate processing apparatus processes a substrate at a pressure higher than the atmospheric pressure.
